Europäisches Patentamt

European Patent Office

Office européen des brevets

(19)

(11) EP 0 782 692 B1

(12) EUROPÄISCHE PATENTSCHRIFT

(45) Veröffentlichungstag und Bekanntmachung des Hinweises auf die Patenterteilung:
**17.11.1999 Patentblatt 1999/46**

(21) Anmeldenummer: **95931894.0**

(22) Anmeldetag: **21.09.1995**

(51) Int Cl.[6]: **G01B 7/06**, G01B 101/00, G01N 27/90

(86) Internationale Anmeldenummer:
**PCT/DE95/01296**

(87) Internationale Veröffentlichungsnummer:
**WO 96/09516 (28.03.1996 Gazette 1996/14)**

(54) **SENSORANORDNUNG UND VERFAHREN ZUR MESSWERTERFASSUNG MIT DER SENSORANORDNUNG**

SENSOR ARRANGEMENT AND METHOD OF DETECTING MEASURED VALUES USING SAID SENSOR ARRANGEMENT

DISPOSITIF DETECTEUR ET PROCEDE POUR LA DETECTION DE VALEURS MESUREES FAISANT APPEL A CE DISPOSITIF

(84) Benannte Vertragsstaaten:
**DE FR GB IT**

(30) Priorität: **22.09.1994 DE 4433772**

(43) Veröffentlichungstag der Anmeldung:
**09.07.1997 Patentblatt 1997/28**

(73) Patentinhaber: **Micro-Epsilon Messtechnik GmbH & Co. KG**
**94496 Ortenburg (DE)**

(72) Erfinder: **MANDL, Roland**
**D-94496 Ortenburg (DE)**

(74) Vertreter: **Naumann, Ulrich, Dr.-Ing. et al**
**Patentanwälte,**
**Ullrich & Naumann,**
**Luisenstrasse 14**
**69115 Heidelberg (DE)**

(56) Entgegenhaltungen:
**DE-A- 4 201 502**

- **PATENT ABSTRACTS OF JAPAN vol. 013 no. 210 (P-872) ,17.Mai 1989 & JP,A,01 028525 (MITSUBISHI ELECTRIC CORP) 31.Januar 1989,**
- **PATENT ABSTRACTS OF JAPAN vol. 015 no. 079 (P-1170) ,25.Februar 1991 & JP,A,02 296157 (SUMITOMO ELECTRIC IND LTD) 6.Dezember 1990,**
- **PATENT ABSTRACTS OF JAPAN vol. 012 no. 266 (P-735) ,26.Juli 1988 & JP,A,63 052008 (NIPPON SHARYO SEIZO KAISHA LTD) 5.März 1988,**
- **PATENT ABSTRACTS OF JAPAN vol. 005 no. 032 (P-050) ,27.Februar 1981 & JP,A,55 155265 (TOYOTA CENTRAL RES & DEV LAB INC;OTHERS: 01) 3.Dezember 1980,**
- **MATERIALS EVALUATION, MARCH 1990, USA, Bd. 48, Nr. 3, ISSN 0025-5327, Seiten 342-347, UDPA L ET AL 'Eddy current defect characterization using neural networks'**
- **SICE '93. PROCEEDINGS OF THE 32ND SICE ANNUAL CONFERENCE. INTERNATIONAL SESSION (IEEE CAT. NO.93 TH 0575-1), 1993 32ND SICE ANNUAL CONFERENCE, KANAZAWA, JAPAN, 4-6 AUG. 1993, ISBN 0-7803-1403-4, 1993, TOKYO, JAPAN, SOC. INSTRUM. & CONTROL ENG, JAPAN, Seiten 1483-1486, CHANDE P K ET AL 'Neural network based sensor integration for on-line weld quality control'**

EP 0 782 692 B1

**Beschreibung**

Die Erfindung betrifft ein Verfahren zur Meßwerterfassung mit einer Sensoranordnung, umfassend mindestens eine Meßspule, mindestens eine Spannungsquelle für die Meßspule und eine Auswerteeinheit mit Mitteln zum Erfassen, Verarbeiten und Auswerten von Meßsignalen, wobei die Auswerteeinheit zum Auswerten der Meßsignale ein neuronales Netzwerk mit einer Eingangsschicht, mindestens einer verdeckten Schicht, einer Ausgangsschicht und Verknüpfungsgewichten für die einzelnen Schichten, d. h. die Knoten der einzelnen Schichten, umfaßt und die Verknüpfungsgewichte in einer Lernphase durch Messungen an mehreren verschiedenen geeigneten Lernobjekten mit bekanntem Ist-Wert bestimmt und abgespeichert sind, wobei für zu bestimmende Ist-Werte mindestens so viele nicht linear abhängige aber in einem physikalisch-mathematischen Zusammenhang stehende Eingangsgrößen für das neuronale Netzwerk ermittelt werden wie Eingangsknoten vorhanden sind, indem als Meßsignale der Spannungsverlauf $U_x$ und der Stromverlauf $I_x$ an der Meßspule bei unterschiedlichen Frequenzen erfaßt werden.

Die Erfindung betrifft außerdem eine Sensoranordnung mit mindestens einer Meßspule, mindestens einer Spannungsquelle für die Meßspule Lind einer Auswerteeinheit mit Mitteln zum Erfassen, Verarbeiten und Auswerten von Meßsignalen, wobei die Auswerteeinheit zum Auswerten der Meßsignale ein neuronales Netzwerk mit einer Eingangsschicht, mindestens einer verdeckten Schicht, einer Ausgangsschicht und Verknüpfungsgewichten für die einzelnen Schichten, d. h. die Knoten der einzelnen Schichten, umfaßt und die Verknüpfungsgewichte in einer Lernphase durch Messungen an mehreren verschiedenen geeigneten Lernobjekten mit bekanntem Ist-Wert bestimmt und abgespeichert sind.

Derartige Wirbelstromsensoren werden seit Jahren für die unterschiedlichsten Messungen eingesetzt, wie beispielsweise zur Abstandsmessung und Schichtdikkenmessung, zur Messung der Leitfähigkeit und magnetischen Permeabilität eines Targets oder zum Überprüfen der Homogenität und zum Erkennen von Schäden in der Struktur der Target-Oberfläche. Für Messungen mit den bekannten Sensoranordnungen ist in der Regel ein umfangreiches Wissen über die physikalischen Zusammenhänge zwischen der zu bestimmenden Größe, der Meßgröße und etwaigen Störgrößen erforderlich. Dieses muß oftmals in eine speziell auf das Meßproblem angepaßte Meß- und Auswerteelektronik umgesetzt werden. Manche Messungen können überhaupt nicht durchgeführt werden, da sich verschiedene Einflußgrößen so überlagern, daß sich keine eindeutige Meßaussage ergibt. Bei der Dickenmessung einer leitfähigen Schicht auf einem ebenfalls leitfähigen Träger mit einer bekannten Sensorenordnung treten bspw. trotz Anpassung an das jeweilige Target-Material Meßfehler auf, wenn z.B. örtliche Inhomogenitäten in Zusammensetzung, Magnetisierung, Leiffähigkeit, effektiver Permeabilität, Temperaturgradienten, etc. bestehen. Die mathematischen Zusammenhänge zwischen Stör- und Meßgrößen müssen bei Verwendung von aus dem Stand der Technik bekannten Sensoranordnungen für jedes Meßproblem neu herausgefunden werden und sind zum Teil so komplex und hochgradig nichtlinear, daß dieser Vorgang - falls überhaupt möglich - enorme Zeit in Anspruch nimmt.

Die Komplexität der mathematischen Zusammenhänge zwischen Stör- und Meßgrößen soll am Beispiel der berührungslosen Abstandsmessung nach dem Wirbelstromprinzip veranschaulicht werden. Die Impedanz einer Spule (Real- und Imaginärteil) ändert sich bei Annäherung eines elektrisch und/oder magnetisch leitfähigen Objekts. Über die Messung der Impedanz einer Meßspule kann also der Abstand Spule/Meßobjekt bestimmt werden. Im Meßobjekt wird dabei ein Strom induziert, der der Erregung der Spule entgegenwirkt. Diese Rückwirkung ist ihrerseits abhängig von der elektrischen Leitfähigkeit und vom magnetischen Verhalten des Meßobjektes, also den Materialparametern. Diese sind wiederum temperaturabhängig. Die Impedanzwerte sind weiterhin frequenzabhängig und stehen in einem nichtlinearen Zusammenhang zum Meßabstand. Zuverlässige Meßergebnisse können nur erzielt werden, wenn all diese Einflußgrößen berücksichtigt werden.

Aus Materials Evaluation vom März 1990, verfaßt von Udpa L. et al ist der Einsatz von neuronalen Netzwerken bei der Auswertung von Meßsignalen eines Wirbelstromsensors, der für die zerstörungsfreie Prüfung von Werkstücken eingesetzt wird, bekannt. Dabei wird aus den Ausgangssignalen der Meßspule ein Satz von acht Fourier-Deskriptoren erzeugt, der als Eingangsdatensatz eines neuronalen Netzwerks dient. Die Fourier-Deskriptoren repräsentieren ein Ausgangssignal der Meßspule, das beim Abfahren einer Probe erfaßt worden ist. Ein Verfahren zur Ermittlung der Fourier-Deskriptoren ist in der Druckschrift jedoch nicht offenbart.

Aus SICE 1993, proceedings of the 32$^{nd}$ SICE annual conference, von Chande P. K. et al, ist ein Wirbelstromsensor zur Qualitätssicherung im Rahmen von Lichtbogenschweißverfahren bekannt. Unter anderem wird hier auch die Oberflächenqualität geprüft, wozu eine Wirbelstromsensor verwendet wird. Auch hier wird für die Auswertung der Sensorsignale ein neuronales Netzwerk eingesetzt. Die Meßspule des bekannten Wirbelstromsensors wird mit einer Speisepannung einer festgesetzten Frequenz betrieben. Zur Messung wird die Meßspule über die Meßprobe bzw. die zu prüfende Schweißstelle bewegt. Der dabei zurückgelegte Weg wird in eine Anzahl von Wegabschnitten aufgeteilt, die der Anzahl von Knoten der Eingangsebene des neuronalen Netzwerks entspricht. Als Eingangsgrößen für das neuronale Netzwerk dienen hier jeweils die in den einzelnen Wegabschnitten erfaßten Amplituden der Oszillatorfrequenz der Meßspule.

Aus der DE-A-42 01 502 ist ein Verfahren und eine Anordnung zur elektrischen Wirbelstromprüfung bekannt.

Dazu werden eine oder mehrere in einer Meßschaltung angeordnete Meßspulen an die Oberfläche eines elektrisch leitfähigen Prüflings angekoppelt. Zur Meßwerterfassung wird die Meßschaltung mit einer Wechselspannung beaufschlagt bzw. nacheinander mit Wechselspannungen unterschiedlicher Frequenz betrieben. Gleichzeitig wird die Meßschaltung bzw. die entsprechende Sensoranordnung über den Prüfling geführt. Im Rahmen des bekannten Verfahrens werden für jede Frequenz und jeden Meßort zwei Meßsignale erfaßt, die von der komplexen Impedanz der Meßschaltung abhängen, da die Induktivität der Meßspule und damit die komplexe Impedanz der diese Meßspule enthaltenden Meßschaltung durch die vom magnetischen Wechselfeld der Meßspule im Prüfling erzeugten Wirbelströme beeinflußt wird. Die Meßsignale werden nun einem neuronalen Netzwerk zugeführt, wo sie je nach Struktur des neuronalen Netzwerks zu einem oder mehreren Mischsignalen verarbeitet werden.

Die Mischsignale am Ausgang des neuronalen Netzwerks ermöglichen eine Klassifizierung der Meßsignale, so daß beispielsweise eine Aussage darüber gemacht werden kann, ob der Prüfling Materialfehler aufweist und gegebenenfalls welcher Art diese Materialfehler sind. Das neuronale Netzwerk dient hier also sowohl zur Verarbeitung als auch zur Auswertung der Meßsignale.

Der vorliegenden Erfindung liegt die Aufgabe zugrunde, das bekannte Verfahren und die bekannte Vorrichtung zur Meßwerterfassung so weiterzubilden, daß die Erfassung der Meßwerte einfach und zügig erfolgen kann, wobei die Anfälligkeit für Meßfehler stark reduziert ist.

Das erfindungsgemäße Verfahren löst die voranstehende Aufgabe durch die Merkmale des Patentanspruchs 1. Danach ist das eingangs genannte Verfahren derart weitergebildet, daß die Meßspule mit einer mehrere Frequenzkomponenten umfassenden Speisespannung beaufschlagt wird, so daß die Erfassung des Spannungsverlaufs $U_x$ und des Stromverlaufs $I_x$ an der Meßspule bei mehreren Frequenzen gleichzeitig erfolgt, und daß die Spektren des digitalisierten Spannungsverlaufs $U_x$ und des digitalisierten Stromverlaufs $I_x$ in einem iterativen Verfahren mit Hilfe eines spektralen Schätzers ermittelt werden als

$$X_{n+1}(f) = x_n(t) \cdot \left( \frac{1}{n+1} \right) \cdot e^{j \left( 2\pi \frac{anT}{T_0} \right)} + \left[ 1 - \left( \frac{1}{n+1} \right) \right] X_n(f)$$

wobei n den Iterationsschritt angibt, $x_n(t)$ der Abtastwert zum Zeitpunkt t, $X_n(f)$ das zugehörige, im n'ten Iterationsschritt ermittelte Spektrum und $X_{n+1}(f)$ das daraus im Iterationsschritt n+1 berechnete Spektrum ist. Mit dem Term $aT/T_0$ wird die gewünschte Spektrallinie ausgewählt. Als Startwert der Iteration verwendet man n=0 und $X_0(f)=0$.

X(f) ist eine komplexe Größe, x(t) reell. Für $nT=T_0$ (eine Periodendauer) entspricht das Ergebnis exakt dem einer diskreten Fourier-Transformation. Das gilt auch für ganzzahlige Vielfache einer Periode. Das Verfahren stellt somit einen spektralen Schätzer dar.

Mit diesem Verfahren soll dem Benutzer einer erfindungsgemäßen Sensoranordnung ein Automatismus zur Verfügung gestellt werden, mit dem er - ohne Kenntnis der mathematischen Hintergründe - Messungen unterschiedlicher Art durchführen kann.

Die Meßwerterfassung muß dazu so ausgeführt werden, daß für zu bestimmende Ist-Werte so viele nicht linear zusammenhängende - also unkorrelierte - aber in einem physikalisch-mathematischen Zusammenhang stehende Eingangsgrößen für das neuronale Netzwerk ermittelt werden wie Eingangsknoten vorhanden sind. Es ist erkannt worden, daß die Impedanzwerte der Meßspule bei unterschiedlichen Meßfrequenzen die Erfordernisse der Eingangsgrößen von neuronalen Netzwerken erfüllen. In der Meßphase werden daher die Impedanzwerte der Meßspule bei verschiedenen Frequenzen ermittelt und entsprechend normiert an den Eingang des neuronalen Netzwerks gelegt. Dazu werden als Meßsignale der Spannungsverlauf und der Stromverlauf an der Meßspule bei unterschiedlichen Frequenzen erfaßt.

In einer besonders vorteilhaften Variante des erfindungsgemäßen Verfahrens wird als Speisespannung für die Meßspule eine spezielle Rechteckspannung verwendet. Der spektrale Anteil höherer Harmonischer fällt bei einer reinen Rechteckspannung mit zunehmender Frequenz ab. Dies wird durch Hinzufügen von drei weiteren Rechtecksignalen geringerer Amplitude für die ersten vier Spektrallinien kompensiert. Eine derartige Kompensation ist vorteilhaft, da die erreichbare Auflösung des A/D-Umsetzers für alle verwendeten Frequenzen gleich groß ist und auf diese Weise eine optimale Aussteuerung mit großer Dynamik realisierbar ist. Die Rechteckspannung wird also in vorteilhafter Weise durch eine periodisch wiederkehrende Abfolge von jeweils einem Rechteckpuls größerer Amplitude und drei Rechteckpulsen kleinerer Amplitude gebildet.

Vorteilhaft ist es außerdem, wenn der alternierenden Speisespannung der Meßspule ein Gleichstromanteil überlagert wird. Durch den gemessenen Strom können Rückschlüsse auf die Temperatur der Meßspule gezogen werden. Der rein ohmsche Anteil der Spulenimpedanz kann dem neuronalen Netzwerk als zusätzliche Eingangsgröße zugeführt werden, womit auf einfache Weise eine Temperaturkompensation des Sensors erreicht wird.

Die Aufgabe der vorliegenden Erfindung wird auch durch eine Sensoranordnung mit den Merkmalen des Patentanspruchs 7 gelöst. Danach ist die eingangs erwähnte Sensoranordnung erfindungsgemäß derart ausgestaltet, daß der Spannungsquelle eine Mischeranordnung nachgeschaltet ist, mit der wahlweise Speisespannungen unterschiedlicher Amplitude und Frequenz erzeugbar sind.

Erfindungsgemäß ist erkannt worden, daß durch die der Spannungsquelle nachgeschaltete Mischeranordnung wahlweise Speisespannungen unterschiedlicher Amplitude und Frequenz erzeugbar sind. Die Messung bzw. Erfassung der Impedanz der Meßspule bei unterschiedlichen Frequenzen der Speisespannung stellt nämlich eine Möglichkeit der Realisierung unkorrelierter, aber in einem physikalisch-mathematischen Zusammenhang stehender Eingangsgrößen für das neuronale Netzwerk dar.

Die Sensoranordnung ist derart ausgestaltet, daß die Auswerteeinheit zum Auswerten der Meßsignale ein neuronales Netzwerk mit einer Eingangsschicht, mindestens einer verdeckten Schicht, einer Ausgangsschicht und Verknüpfungsgewichten für die einzelnen Schichten umfaßt und daß die Verknüpfungsgewichte in einer Lernphase durch Messungen an mehreren verschiedenen geeigneten Lernobjekten mit bekanntem Ist-Wert bestimmt und abgespeichert sind.

Um nun linear unabhängige Meßgrößen zur Speisung des neuronalen Netzwerkes zu gewinnen, wird als Bestandteil der Auswerteeinheit eine Schaltungsanordnung in Vierleitertechnik vorgeschlagen, die einen Schaltungszweig zum Erfassen des Spannungsverlaufs und einen Schaltungszweig zum Erfassen des Stromverlaufs der Meßspule umfaßt. Beide Signale werden in der Auswerteeinheit auch verarbeitet, indem sie A/D-gewandelt und komplex dividiert werden. Auf diese Weise wird ein komplexer Impedanzwert ermittelt, der unabhängig von der Amplitude und Phase der Speisespannung ist. Die Auswerteeinheit kann ferner Mittel zum Normieren und Skalieren der Meßsignale umfassen. Erst die so ermittelten Impedanzwerte werden dem neuronalen Netzwerk als Eingangsgröße zugeführt.

Durch Einsatz der Sensoranordnung in Zusammenhang mit dem erfindungsgemäßen Verfahren ist eine detaillierte Kenntnis der physikalisch-mathematischen Zusammenhänge zwischen Stör- und Meßgrößen nicht erforderlich, da zur Auswertung der Meßsignale ein in geeigneter Weise trainiertes neuronales Netzwerk verwendet wird. Es ist ferner erkannt worden, daß sich das neuronale Netzwerk der Sensoranordnung durch geeignete Wahl der Lernobjekte und Messungen in der Lernphase auch für unterschiedliche Arten der Messung trainieren iäßt. Mit der erfindungsgemäßen Sensoranordnung können daher auch unterschiedliche Arten der Messung durchgeführt werden. Ferner ist erkannt worden, daß durch die geeignete optimale Wahl verschiedener Lernobjekte auch gegen unbekannte, also nicht angelernte Meßobjekte gemessen werden kann. Das verwendetet neuronale Netzwerk approximiert die Zusammenhänge so, daß auch zwischen den Lernobjekten liegende Ist-Werte korrekt ermittelt werden können. Eine bei herkömmlichen Systemen übliche Linearisierung oder Kalibrierung ist hierbei in aller Regel nicht mehr notwendig.

Im Falle der berührungslosen Abstandsmessung können die unterschiedlichen Einflüsse von verschiedenen Materialien dadurch eliminiert werden, daß in der Lernphase Messungen an Lernobjekten aus verschiedenen geeigneten Materialien durchgeführt werden. Sollen die eigentlichen Messungen bspw. an metallischen Materialien durchgeführt werden, dann werden für die Lernphase ebenfalls metallische Materialien verwendet, indem z. B. Lernobjekte aus Alu, Eisen, rostfreiem Stahl, etc. ausgewählt werden. Diese Messungen liefern Eingangsgrößen für das neuronale Netzwerk mit deren Hilfe die Verknüpfungsgewichte des neuronalen Netzwerks ermittelt werden können, da die Ist-Werte der Lernobjekte bekannt sind. Das Gleichungssystem für die Verknüpfungsgewichte ist dabei evtl. mehrfach überbestimmt. In diesem Falle wird eine Quadratmittelapproximation durchgeführt. Unterbestimmte Gleichungssysteme oder stark korrelierte Eingangsgrößen wirken sich durch mangelnden Lernerfolg aus. Nach der Lernphase werden die ermittelten Verknüpfungsgewichte in einem entsprechenden Elektronikteil festgehalten. Durch die Verknüpfungsgewichte wird eine Abbildungsvorschrift des Eingangsvektors der Eingangsgrößen auf einen oder mehrere Ausgangswerte festgelegt. Das neuronale Netzwerk findet damit eine Approximation für einen Zusammenhang, der mathematisch geschlossen nicht lösbar ist. In der Meßphase können dann Abstandsmessungen auch an Meßobjekten durchgeführt werden, die aus einem anderen Material bestehen als irgend eines der Lernobjekte.

In einer vorteilhaften Ausgestaltung der erfindungsgemäßen Sensoranordnung wird als neuronales Netzwek ein Backpropagation-Netzwerk verwendet. Derartige Netzwerkstrukturen sind bereits hinreichend aus der Literatur bekannt, so daß an dieser Stelle nicht näher auf die konkrete Ausgestaltung eines BackpropagationNetzwerkes eingegangen werden muß. Angemerkt sei lediglich, daß ein Backpropagation-Netzwerk eine rückkopplungsfreie Netzwerkstrukutur aufweist.

Es gibt nun verschiedene Möglichkeiten der Realisierung eines derartigen Netzwerkes. Gute Ergebnisse wurden mit einer einstufigen Netzwerkstruktur erzielt, die nur eine verdeckte Schicht aufweist. Beispielhaft seien hier unterschiedliche Typen einer einstufigen Netzwerkstruktur aufgeführt, mit denen akzeptable Ergebnisse erzielt wurden:

Typ 1: Acht Eingangsknoten, fünf Knoten in der verdeckten Schicht und ein Ausgangsknoten,

Typ 2: Acht Eingangsknoten, ein Knoten in der verdeckten Schicht und ein Ausgangsknoten,

Typ 3: Sechs Eingangsknoten, fünf Knoten in der verdeckten Schicht und ein Ausgangsknoten,

Typ 4: Vier Eingangsknoten, vier Knoten in der verdeckten Schicht und ein Ausgangsknoten,

Typ 5: Zwei Eingangsknoten, zwei Knoten in der verdeckten Schicht und ein Ausgangsknoten.

Denkbar ist aber auch eine zweistufige Netzwerkstruktur mit zwei verdeckten Schichten.

In einer besonders vorteilhaften Ausgestaltung der erfindungsgemäßen Sensoranordnung wird als Transferfunktion der Elemente eines Backpropagation-Netzwerkes eine an das Nichtlinearitätsverhalten der Meßspule angepaßte Sigmoidfunktion mit streng monotonem und differenzierbarem Verlauf eingesetzt. Dabei findet zwar eine individuelle Anpassung der Transferfunktion - und damit des neuronalen Netzwerks - an die physikalischen Gegebenheiten der Meßspule statt, die Vorteile eines sigmoidalen Kurvenverlaufs werden jedoch beibehalten. Jeder beliebige Eingangswert wird auf das Intervall zwischen 0 und 1 abgebildet. Außerdem werden Eingangswerte, die nahe bei 0 liegen, durch die Steilheit der Kurve in diesem Bereich stärker auseinandergezogen und damit besser getrennt. Sehr große positive oder negative Werte führen immer zu Aktivitäten nahe 1 respektive nahe 0. Ihre absolute Größe ist durch den in diesen Bereichen sehr flachen Kurvenverlauf verhältnismäßig unerheblich. Die Sigmoidfunktiton hat außerdem den Vorteil, daß ihre Ableitung sehr einfach ist.

Die erfindungsgemäße Sensoranordnung sowie das voranstehende Verfahren zur Meßwerterfassung mit der erfindungsgemäßen Sensoranordnung kann in vorteilhafter Weise zur Abstandsmessung und Schichtdickenmessung verwendet werden. So kann bspw. die Dicke von Metallfolien oder auch die Dicke von Beschichtungen bestimmt werden. Eine weitere vorteilhafte Verwendung der erfindungsgemäßen Sensoranordnung stellt die Messung der elektrischen Leitfähigkeit und der effektiven relativen Permeabilität von Oberflächenschichten dar.

Es gibt nun verschiedene Möglichkeiten, die Lehre der vorliegenden Erfindung in vorteilhafter Weise auszugestalten und weiterzubilden. Dazu ist einerseits auf die den Patentansprüchen 1 und 7 nachgeordneten Ansprüche, andererseits auf die nachfolgende Erläuterung eines Ausführungsbeispiels der Erfindung anhand der Zeichnung zu verweisen. In Verbindung mit der Erläuterung des bevorzugten Ausführungsbeispiels der Erfindung anhand der Zeichnung werden auch im allgemeinen bevorzugte Ausgestaltungen und Weiterbildungen der Lehre erläutert. In der Zeichnung zeigt

Fig. 1  in einem Blockdiagramm den schematischen Aufbau einer erfindungsgemäßen Sensoranordnung,

Fig. 2  eine Schaltung zur Speisung einer Meßspule sowie zum Erfassen von Meßsignalen an der Meßspule im Rahmen der erfindungsgemäßen Sensoranordnung,

Fig. 3  einen Signalverlauf der Speisespannung der Meßspule,

Fig. 4  die in Fig. 3 dargestellte Speisespannung im Frequenzbereich und

Fig. 5  zehn Versuchsergebnisse von Messungen an Metallen mit unbekannten Materialparametern.

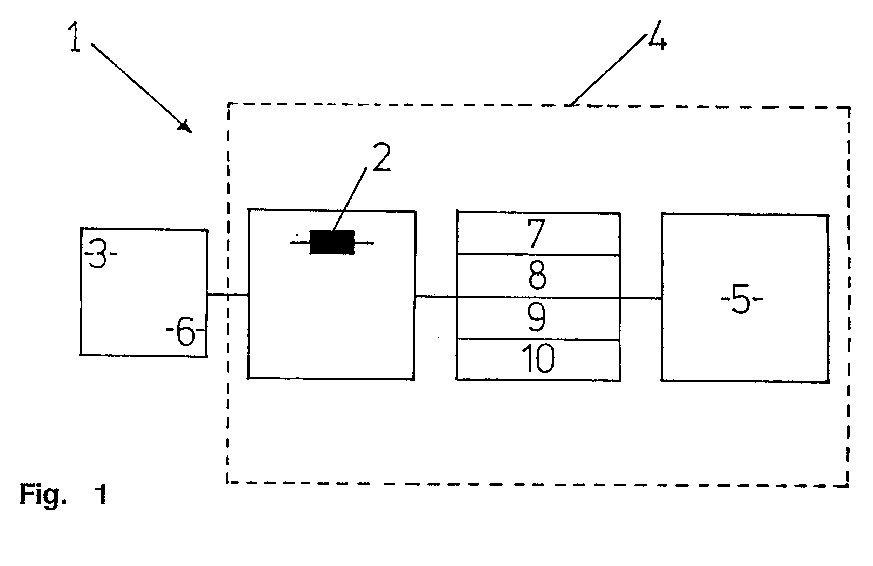

In Fig. 1 ist der prinzipielle Aufbau einer erfindungsgemäßen Sensoranordnung 1 dargestellt. Die Sensoranordnung 1 umfaßt eine Meßspule 2 als Sensorelement und eine Spannungsquelle 3 für die Meßspule 2. Ferner ist eine Auswerteeinheit 4 vorgesehen, die Mittel zum Erfassen, Verarbeiten und Auswerten von Meßsignalen umfaßt.

Erfindungsgemäß dient als Mittel zum Auswerten der Meßsignale ein neuronales Netzwerk 5 mit einer Eingangsschicht, mindestens einer verdeckten Schicht, einer Ausgangsschicht und Verknüpfungsgewichten für die einzelnen Schichten. Die Verknüpfungsgewichte sind in einer Lernphase durch Messungen an mehreren verschiedenen geeigneten Lernobjekten mit bekanntem Ist-Wert bestimmt und abgespeichert.

Bei dem hier dargestellten neuronalen Netzwerk 5 soll es sich um ein Backpropagation-Netzwerk mit einer einstufigen Netzwerkstruktur handeln, d.h. die Netzwerkstruktur weist lediglich eine verdeckte Schicht auf. Die Eingangsschicht des neuronalen Netzwerks soll beispielhaft acht Eingangsknoten umfassen, während die verdeckte Schicht fünf Knoten aufweist und die Ausgangsschicht lediglich durch einen Ausgangsknoten gebildet ist. Als Transferfunktion des neuronalen Netzwerks 5 dient eine an das Nichtlinearitätsverhalten der Meßspule 2 angepaßte Sigmoidfunktion mit streng monotonem und differenzierbarem Verlauf.

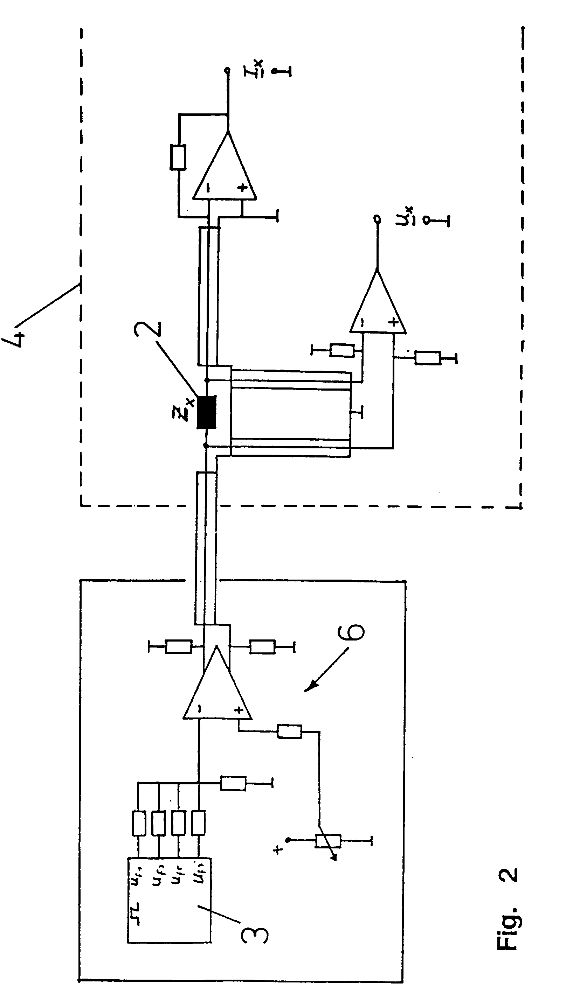

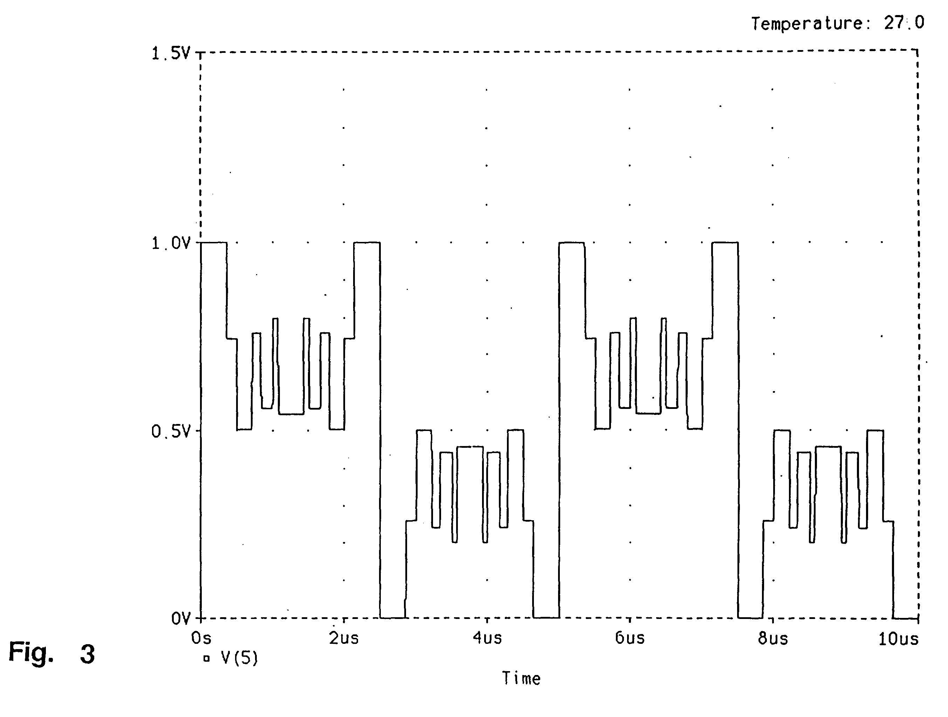

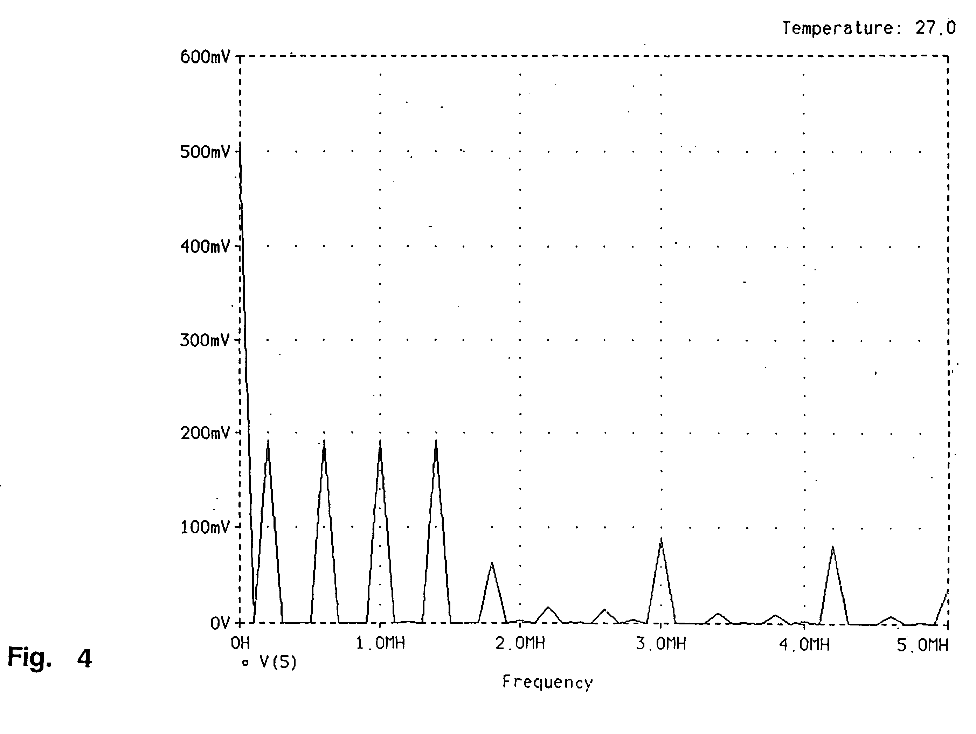

Eine Realisierungsmöglichkeit der Spannungsquelle 3, der Meßspule 2 und der Mittel zum Erfassen der Meßsignale im Rahmen der Auswerteeinheit 4 sind in Fig. 2 dargestellt. Der eigentlichen Spannungsquelle 3 ist eine Mischeranordnung 6 nachgeschaltet, mit der wahlweise Speisespannungen unterschiedlicher Amplitude und Frequenz erzeugbar sind. Mit der dargestellten Mischeranordnung 6 läßt sich eine Speisespannung in Form eines Rechtecksignals realisieren, das durch eine periodisch wiederkehrende Abfolge von jeweils einem Rechteckpuls größerer Amplitude und drei Rechteckpulsen kleinerer Amplitude gebildet ist. Ein derartiger Signalverlauf ist in Fig. 3 dargestellt. Die zugehörige Darstellung im Frequenzbereich ist Fig. 4 entnehmbar. Aus Fig. 4 wird deutlich, daß durch Hinzufügen von mehreren Rechteckpulsen geringerer Amplitude zu einem Rechteckpuls größerer Amplitude ein Signal mit im wesentlichen vier gleich stark vertretenen Frequenzanteilen erzeugt wird.

Durch Speisung der Meßspule 2 mit einem derartigen Rechtecksignal lassen sich also die Impedanzwerte der Meßspule 2 bei diesen vier verschiedenen Frequenzen bestimmen.

Fig. 2 zeigt den Teil der Auswerteeinheit 4, mit dem die Meßsignale, nämlich der Spannungsverlauf $U_x$ und der Stromverlauf $I_x$, an der Meßspule 2 erfaßt werden. Der Spannungsverlauf wird parallel zur Meßspule 2 erfaßt, während der Stromverlauf hinter der Meßspule 2 erfaßt wird. Diese Schaltungsanordnung ist in Vierleitertechnik realisiert, wobei die einzelnen Schaltungszweige abgeschirmt sind.

Sowohl das Spannungssignal als auch das Stromsignal werden A/D-gewandelt und komplex dividiert. Dabei ergeben sich die unkorrelierten Impedanzwerte der Meßspule 2 bei den verschiedenen Frequenzen, die unabhängig von der Amplitude und Phase der Speisespannung sind.

An die in Fig. 2 dargestellte Schaltung schließen sich also die Mittel zur Verarbeitung an, die ebenfalls der Auswerteeinheit 4 zuzurechnen sind. Im einzelnen handelt es sich dabei um Mittel zum Digitalisieren, nämlich einen A/D-Umsetzer 7, Mittel zur Durchführung einer Fourieranalyse für Spannung und Strom 8. Mittel zum komplexen Dividieren bei verschiedenen Frequenzen 9 und schließlich noch Mittel zum komplexen Normieren und Skalieren 10. Erst an diese Signalverarbeitungsstufen schließen sich die Eingangsknoten des neuronalen Netzwerks 5 an. was in Fig. 1 dargestellt ist.

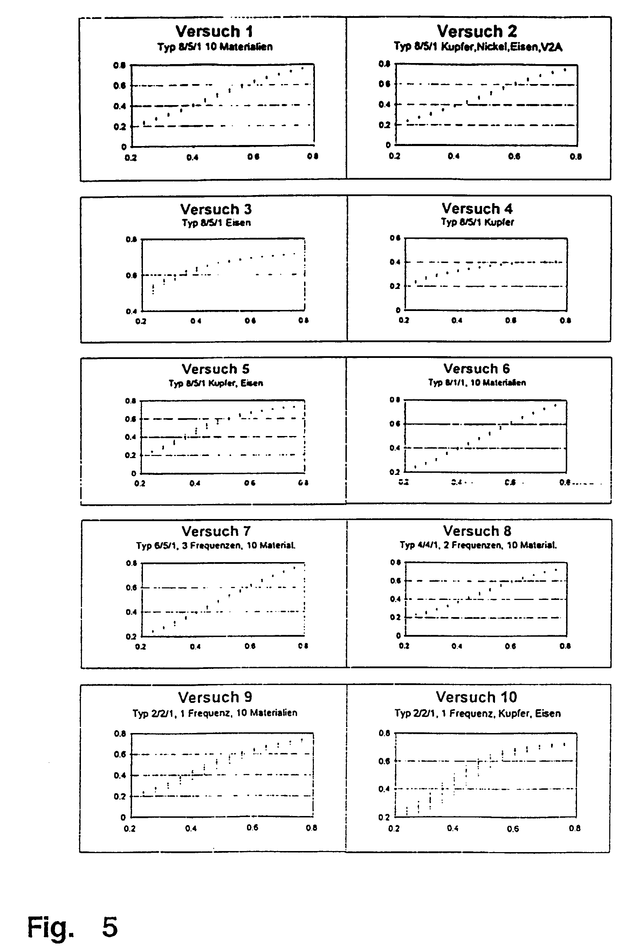

Die Beschriftung der zehn in Fig. 5 dargestellten Versuchsdiagramme von Abstandsmessungen ist wie folgt zu interpretieren:

Bei allen zehn Versuchen wurden einstufige neuronale Netzwerke verwendet, die also lediglich eine verdeckte Schicht aufweisen. Typ 8/5/1 deutet auf eine Netzwerkstruktur mit acht Eingangsknoten, fünf Knoten in der verdeckten Schicht und einem Ausgangsknoten hin. Daneben sind die beim Training verwendeten Materialien angegeben, z.B. Kupfer, Nickel, Eisen oder V2A-Stahl. Der Test wurde immer mit zehn verschiedenen Metallen durchgeführt. Die beiden Achsen entsprechen dem Soll-Abstand bzw. dem vom Netzwerk geschätzten Abstand. Ab Versuch sieben wurde die Anzahl der verwendeten Meßfrequenzen verringert. Man erkennt, daß das Verfahren ab mindestens zwei Frequenzen brauchbare Resultate, also eine gute Korrelation zwischen dem tatsächlichen Abstand und dem ermittelten Abstand ergibt. Eine höhere Anzahl von Meßfrequenzen ergibt jedoch eine größere Approximationsgüte.

Insgesamt lassen sich hierzu folgende Aussagen treffen:

Die Materialeigenschaften von Metallen, die nicht bei den Lernobjekten waren, werden korrekt erkannt und inter- bzw. extrapoliert. Damit kann der Kalibriervorgang entscheidend abgekürzt werden.

Der Klassifikationsalgorithmus der Lernphase bestimmt die Materialparameter, nämlich bspw. die Leitfähigkeit und effektive Permeabilität des Materials, und kompensiert deren Einfluß auf die Abstandsmessung. Materialparameterschwankungen verursacht durch Meßobjekttemperaturänderungen beeinflussen die Abstandsmessung nicht.

Das neuronale Netz findet damit eine Approximation für einen Zusammenhang, der mathematisch geschlossen nicht lösbar ist. Allerdings kann die Approximation aus den erlernten Verbindungsgewichten nicht einfach extrahiert werden. Versuche mit unterschiedlichen Eingangsdaten und Netzstrukturen liefern experimentelle Aussagen über die Lösbarkeit und notwendigen Minimalanforderungen auch ähnlich gelagerter Probleme.

Hinsichtlich vorteilhafter Ausgestaltungen der erfindungsgemäßen Sensoranordnung sowie des erfindungsgemäßen Verfahrens zur Meßwerterfassung mit dieser Sensoranordnung, die in den voranstehend beschriebenen Figuren keinen Niederschlag gefunden haben, wird auf den allgemeinen Teil der Erfindung verwiesen.

Abschließend sei nochmals ausdrücklich darauf hingewiesen, daß die erfindungsgemäße Sensoranordnung nicht nur zur Abstandsmessung und Dickenmessung, sondern auch zur Messung von Materialparametern, wie der elektrischen Leitfähigkeit und der effektiven Permeabilität, eingesetzt werden kann.

**Patentansprüche**

1. Verfahren zur Meßwerterfassung mit einer Sensoranordnung (1), umfassend mindestens eine Meßspule (2), mindestens eine Spannungsquelle (3) für die Meßspule (2) und eine Auswerteeinheit (4) mit Mitteln zum Erfassen, Verarbeiten und Auswerten von Meßsignalen, wobei die Auswerteeinheit (4) zum Auswerten der Meßsignale ein neuronales Netzwerk (5) mit einer Eingangsschicht, mindestens einer verdeckten Schicht, einer Ausgangsschicht und Verknüpfungsgewichten für die einzelnen Schichten, d. h. die Knoten der einzelnen Schichten, umfaßt und die Verknüpfungsgewichte in einer Lernphase durch Messungen an mehreren verschiedenen geeigneten Lernobjekten mit bekanntem Ist-Wert bestimmt und abgespeichert sind, wobei für zu bestimmende Ist-Werte mindestens so viele nicht linear abhängige aber in einem physikalisch-mathematischen Zusammenhang stehende Eingangsgrößen für das neuronale Netzwerk (5) ermittelt werden wie Eingangsknoten vorhanden sind, indem als Meßsignale der Spannungsverlauf $U_X$ und der Stromverlauf $I_X$ an der Meßspule (2) bei unterschiedlichen Frequenzen erfaßt werden,

**dadurch gekennzeichnet,** daß die Meßspule (2) mit einer mehrere Frequenzkomponenten umfassenden Speisespannung beaufschlagt wird, so daß die Erfassung des Spannungsverlaufs $U_X$ und des Stromverlaufs $I_X$ an der Meßspule (2) bei mehreren Frequenzen gleichzeitig erfolgt, und daß die Spektren des digitalisierten Spannungsverlaufs $U_X$ und des digitalisierten Stromverlaufs $I_X$ in einem iterativen Verfahren mit Hilfe eines spektralen Schätzers ermittelt werden als

$$X_{n+1}(f) = x_n(t) \cdot \left(\frac{1}{n+1}\right) \cdot e^{j\left[2\pi\frac{anT}{T_0}\right]} + \left[1 - \left(\frac{1}{n+1}\right)\right] X_n(f)$$

wobei n den Iterationsschritt angibt, $x_n$(t) der Abtastwert zum Zeitpunkt t, $X_n$(f) das zugehörige, im n'ten Iterationsschritt ermittelte Spektrum und $X_{n+1}$(f) das daraus im Iterationsschritt n+1 berechnete Spektrum ist, mit dem Term $aT/T_0$ die gewünschte Spektrallinie ausgewählt wird und als Startwert der Iteration n=0 und $X_0$(f)=0 gewählt wird.

2. Verfahren nach Anspruch 1, dadurch gekennzeichnet, daß aus dem Spannungsverlauf $U_X$ und dem Stromverlauf $I_X$ die Impedanzwerte der Meßspule (2) bei unterschiedlichen Frequenzen als Eingangsgrößen für das neuronale Netzwerk (5) bestimmt werden.

3. Verfahren nach einem der Ansprüche 1 oder 2, dadurch gekennzeichnet, daß die Meßspule (2) mit einer Rechteckspannung gespeist wird.

4. Verfahren nach Anspruch 3, dadruch gekennzeichnet, daß die Rechteckspannung durch eine periodisch wiederkehrende Abfolge von jeweils einem Rechteckpuls größerer Amplitude und drei Rechteckpulsen kleinerer Amplitude gebildet wird.

5. Verfahren nach einem der Ansprüche 1 bis 4, dadurch gekennzeichnet, daß die Speisespannung der Meßspule (2) neben einem Wechselstromanteil auch einen Gleichstromanteil umfaßt.

6. Verfahren nach Anspruch 5, dadurch gekennzeichnet, daß der rein ohmsche Anteil der Impedanzwerte der Meßspule (2) eine Eingangsgröße für das neuronale Netzwerk (5) bildet.

7. Sensoranordnung, umfassend mindestens eine Meßspule (2), mindestens eine Spannungsquelle (3) für die Meßspule (2) und eine Auswerteeinheit (4) mit Mitteln zum Erfassen, Verarbeiten und Auswerten von Meßsignalen, wobei die Auswerteeinheit (4) zum Auswerten der Meßsignale ein neuronales Netzwerk (5) mit einer Eingangsschicht, mindestens einer verdeckten Schicht, einer Ausgangsschicht und Verknüpfungsgewichten für die einzelnen Schichten, d. h. die Knoten der einzelnen Schichten, umfaßt und die Verknüpfungsgewichte in einer Lernphase durch Messungen an mehreren verschiedenen geeigneten Lernobjekten mit bekanntem Ist-Wert bestimmt und abgespeichert sind, zur Durchführung eines Verfahrens nach einem der Ansprüche 1 bis 6,
**dadurch gekennzeichnet,** daß der Spannungsquelle (3) eine Mischeranordnung (6) nachgeschaltet ist, mit der wahlweise Speisespannungen unterschiedlicher Amplitude und Frequenz erzeugbar sind.

8. Sensoranordnung nach Anspruch 7, dadurch gekennzeichnet, daß die Auswerteeinheit (4) eine Schaltungsanordnung in Vierleitertechnik mit einem Schaltungszweig zum Erfassen des Spannungsverlaufs $U_X$ und einem Schaltungszweig zum Erfassen des Stromverlaufs $I_X$ der Meßspule (2) umfaßt.

9. Sensoranordnung nach einem der Ansprüche 7 oder 8, dadurch gekennzeichnet. daß die Auswerteeinheit Mittel zum Digitalisieren (7). zum Durchführen einer Fourier-Analyse (8), zum komplexen Dividieren (9) und Normieren und Skalieren (10) der Meßsignale umfaßt und daß diese Mittel zum Verarbeiten (7, 8, 9, 10) der Meßsignale dem neuronalen Netzwerk (5) vorgeschaltet sind.

10. Sensoranordnung nach einem der Ansprüche 7 bis 9, dadurch gekennzeichnet, daß das neuronale Netzwerk (5) ein Backpropagation-Netzwerk ist.

11. Sensoranordnung nach einem der Ansprüche 7 bis 10, dadurch gekennzeichnet, daß das neuronale Netzwerk (5) eine einstufige Netzwerkstruktur, d. h. eine Netzwerkstruktur mit einer verdeckten Schicht, aufweist.

12. Sensoranordnung nach Anspruch 11, dadurch gekennzeichnet, daß die Eingangsschicht des neuronalen Netzwerks (5) acht, sechs, vier oder zwei Eingangsknoten aufweist.

13. Sensoranordnung nach einem der Ansprüche 11 oder 12, dadurch gekennzeichnet, daß die verdeckte Schicht des neuronalen Netzwerks (5) fünf, vier, zwei oder einen Knoten aufweist.

14. Sensoranordnung nach einem der Ansprüche 7 bis 10, dadurch gekennzeichnet, daß das neuronale Netzwerk eine zweistufige Netzwerkstruktur, d. h. eine Netzwerkstruktur mit zwei verdeckten Schichten, aufweist.

15. Sensoranordnung nach einem der Ansprüche 7 bis 14, dadurch gekennzeichnet, daß die Ausgangsschicht des neuronalen Netzwerks (5) einen Ausgangsknoten aufweist.

16. Sensoranordnung nach einem der Ansprüche 7 bis 15, dadurch gekennzeichnet, daß eine an das Nichtlinearitätsverhalten der Meßspule (2) angepaßte Sigmoidfunktion mit streng monotonem und differenzierbarem Verlauf als Transferfunktion des neuronalen Netzwerks (5) dient.

17. Verwendung eines Verfahrens nach einem der Ansprüche 1 bis 6 zur Abstandsmessung und Schichtdickenmessung.

18. Verwendung eines Verfahrens nach einem der Ansprüche 1 bis 6 zur Messung der elektrischen Leitfähigkeit und der effektiven relativen Permeabilität.

## Claims

1. Method of detecting measured values using a sensor arrangement (1), comprising at least one measuring coil (2), at least one voltage source (3) for the measuring coil (2) and an evaluating unit (4) having means for detecting, processing and evaluating measured signals, the evaluating unit (4), for evaluating the measured signals, including a neural network (5) having an input layer, at least one hidden layer, an output layer and linking weights for the individual layers, that is to say, the nodes of the individual layers, and the linking weights being determined and stored in a learning phase by measurements using several different suitable learning objects having a known actual value, and, for actual values to be determined, at least as many input quantities that are non-linearly-dependent but in a physical-mathematical relationship, being determined for the neural network (5) as there are input nodes present, in that the voltage characteristic $U_x$ and the current characteristic $I_x$ are detected as measured signals at the measuring coil (2) at different frequencies, characterised in that the measuring coil (2) is acted upon by a supply voltage comprising several frequency components, so that the detection of the voltage characteristic $U_x$ and the current characteristic $I_x$ at the measuring coil (2) takes place simultaneously at several frequencies, and in that the spectra of the digitalised voltage characteristic $U_x$ and of the digitalised current characteristic $I_x$ are determined in an iterative method with the aid of a spectral estimator as

$$X_{n+1}(f) = x_n(t) \cdot \left(\frac{1}{n+1}\right) \cdot e^{j\left(2\pi \frac{anT}{T_0}\right)} + \left[1 - \left(\frac{1}{n+1}\right)\right] X_n(f)$$

wherein n indicates the iteration step, $x_n(t)$ is the sampling value at time t, $X_n(f)$ is the associated spectrum determined in the nth iteration step and $X_{n+1}(f)$ is the spectrum calculated therefrom in the iteration step n+1, the desired spectral line is selected with the term $aT/T_0$ and n=0 and $X_0(f)=0$ is selected as the starting value of the iteration.

2. Method according to claim 1, characterised in that the impedance values of the measuring coil (2) at different frequencies are determined from the voltage characteristic $U_x$ and the current characteristic $I_x$ as input quantities for the neural network (5).

3. Method according to either claim 1 or claim 2, characterised in that the measuring coil (2) is supplied with a rectangular voltage.

4. Method according to claim 3, characterised in that the rectangular voltage is formed by a periodically recurring sequence of, in each case, one rectangular pulse of larger amplitude and three rectangular pulses of smaller amplitude.

5. Method according to any one of claims 1 to 4, characterised in that the supply voltage of the measuring coil (2) comprises, in addition to an alternating current component, a direct current component.

6. Method according to claim 5, characterised in that the purely resistance component of the impedance values of the measuring coil (2) forms an input quantity for the neural network (5).

7. Sensor arrangement, comprising at least one measuring coil (2), at least one voltage source (3) for the measuring coil (2) and an evaluating unit (4) having means for detecting, processing and evaluating measured signals, the evaluating unit (4), for evaluating the measured signals, including a neural network (5) having an input layer, at least one hidden layer, an output layer and linking weights for the individual layers, that is to say, the nodes of the individual layers, and the linking weights being determined and stored in a learning phase by measurements using several different suitable learning objects having a known actual value, for carrying out a method according to any one of claims 1 to 6, characterised in that a mixer arrangement (6) by means of which supply voltages of different amplitude and frequency can be generated as desired is arranged downstream of the voltage source (3).

8. Sensor arrangement according to claim 7, characterised in that the evaluating unit (4) comprises a circuit arrangement in four-conductor technology having a circuit branch for detecting the voltage characteristic $U_x$ and a circuit branch for detecting the current characteristic $I_x$ of the measuring coil (2).

9. Sensor arrangement according to either claim 7 or claim 8, characterised in that the evaluating unit comprises means for the digitalisation (7), for carrying out a Fourier analysis (8), for the complex division (9) and standardisation and scaling (10) of the measured signals and in that those means for processing (7, 8, 9, 10) the measured signals are arranged upstream of the neural network (5).

10. Sensor arrangement according to any one of claims 7 to 9, characterised in that the neural network (5) is a back propagation network.

11. Sensor arrangement according to any one of claims 7 to 10, characterised in that the neural network (5) has a one-step network structure, that is to say, a network structure having one hidden layer.

12. Sensor arrangement according to claim 11, characterised in that the input layer of the neural network (5) has eight, six, four or two input nodes.

13. Sensor arrangement according to either claim 11 or claim 12, characterised in that the hidden layer of the neural network (5) has five, four, two or one node(s).

14. Sensor arrangement according to any one of claims 7 to 10, characterised in that the neural network has a two-step network structure, that is to say, a network structure having two hidden layers.

15. Sensor arrangement according to any one of claims 7 to 14, characterised in that the output layer of the neural network (5) has one output node.

16. Sensor arrangement according to any one of claims 7 to 15, characterised in that a sigmoid function adapted to the non-linearity behaviour of the measuring coil (2) and having a strictly monotonic and differentiable characteristic is used as the transfer function of the neural network (5).

17. Use of a method according to any one of claims 1 to 6 for distance measurement and layer thickness measurement.

18. Use of a method according to any one of claims 1 to 6 for measuring electrical conductivity and effective relative permeability.

**Revendications**

1.  Procédé pour la détection de valeurs mesurées avec un dispositif détecteur (1), comprenant au moins une bobine de mesure (2), au moins une source de potentiel (3) pour la bobine de mesure et une unité d'évaluation (4) avec des moyens pour saisir, traiter et évaluer des signaux de mesure, où l'unité d'évaluation (4) pour évaluer les signaux de mesure comprend un réseau neuronal (5) avec une couche d'entrée, au moins une couche cachée, une couche de sortie et des pondérations de réticulation pour les différentes couches, c'est-à-dire pour les noeuds des différentes couches, et où les pondérations de réticulation sont au cours d'une phase d'apprentissage déterminées par des mesures effectués sur plusieurs objets d'apprentissage appropriés ayant une valeur réelle connue et sont mises en mémoire, où pour les valeurs réelles à déterminer sont déterminées pour le réseau neuronal (5) au moins autant de grandeurs d'entrée non dépendantes linéairement mais en corrélation physicomathématique qu'il existe de noeuds d'entrée, par le fait qu'en tant que signaux de mesure sont saisies l'allure de potentiel $U_x$ et l'allure d'intensité $I_x$ au niveau de la bobine de mesure (2) pour des fréquences variables,
    caractérisé en ce que la bobine de mesure (2) est soumise à une tension d'alimentation comprenant plusieurs composantes de fréquence, de telle sorte que la saisie de l'allure de potentiel $U_x$ et de l'allure d'intensité $I_x$ au niveau de la bobine de mesure (2) a lieu simultanément pour plusieurs fréquences, et en ce que les spectres de l'allure de potentiel $U_x$ digitalisée et de l'allure d'intensité $I_x$ digitalisée sont déterminées par un procédé itératif à l'aide d'un évaluateur spectral en tant que

$$X_{n+1}(f) = x_n(t) \cdot \left( \frac{1}{n+1} \right) \cdot e^{j\left( 2\pi \frac{anT}{T_0} \right)} + \left[ 1 - \left( \frac{1}{n+1} \right) \right] X_n(f)$$

où n est le pas d'itération, $x_n(t)$ la valeur de balayage à l'instant t, $X_n(f)$ le spectre correspondant déterminée lors du nième pas itératif et $X_{n+1}(f)$ le spectre calculé sur cette base pour le pas d'itération n+1, le terme $aT/T_o$ servant à choisir la ligne spectrale désirée et qu'en tant que valeur de démarrage de l'itération est choisi n=0 et $X_o(f)$=0

2.  Procédé suivant la revendication 1, caractérisé en ce qu'en fonction de l'allure de potentiel $U_x$ et de l'allure d'intensité $I_x$ sont déterminées mes valeurs d'impédance de la bobine de mesure (2) pour différentes fréquences en tant que grandeurs d'entrée pour le réseau neuronal (5).

3.  Procédé suivant l'une des revendications 1 ou 2, caractérisé en ce que la bobine de mesure est alimentée en une tension rectangulaire.

4.  Procédé suivant la revendication 3, caractérisé en ce que la tension rectangulaire est formée par une séquence revenant périodiquement de chaque fois une impulsion de plus grande amplitude et trois impulsions de plus petite amplitude.

5.  Procédé suivant l'une quelconque des revendications de 1 à 4, caractérisé en ce que ka tension d'alimentation de la bobine de mesure (2) comprend, outre une proportion de courant alternatif, également une proportion de courant continu.

6.  Procédé suivant la revendication 5, caractérisé en ce que la proportion purement ohmique des valeurs d'impédance de la bobine de mesure (2) constitue une grandeur d'entrée pour le réseau neuronal (5).

7.  Dispositif détecteur comprenant au moins une bobine de mesure (2), au moins une source de potentiel (3) pour la bobine de mesure et une unité d'évaluation (4) avec des moyens pour saisir, traiter et évaluer des signaux de mesure, où l'unité d'évaluation (4) pour évaluer les signaux de mesure comprend un réseau neuronal (5) avec une couche d'entrée, au moins une couche cachée, une couche de sortie et des pondérations de réticulation pour les différentes couches, c'est-à-dire pour les noeuds des différentes couches, et où les pondérations de réticulation sont au cours d'une phase d'apprentissage déterminées par des mesures effectués sur plusieurs objets d'apprentissage appropriés ayant une valeur réelle connue et sont mises en mémoire, pour la mise en oeuvre d'un procédé suivant l'une quelconque des revendications de 1 à 6,
    caractérisé en ce que la source de potentiel (3) est suivie d'un dispositif de mixage (6) permettant de produire à volonté des tensions d'alimentation d'amplitude et de fréquence différentes.

**8.** Dispositif détecteur suivant la revendication 7, caractérisé en ce que l'unité d'évaluation (4) comprend un circuit du type à quatre conducteurs avec une branche pour la saisie de l'allure de potentiel $U_x$ et une branche pour la saisie de l'allure d'intensité $I_x$ de la bobine de mesure (2).

**9.** Dispositif détecteur suivant l'une ou l'autre des revendications 7 et 8, caractérisé en ce que l'unité d'évaluation comprend des moyens pour la digitalisation (7), pour l'exécution d'une analyse de Fourier (8), pour la division complexe (9) et pour la normalisation et la graduation (10) des signaux de mesure, et en ce que ces moyens pour le traitement (7, 8, 9, 10) des signaux de mesure sont couplés en amont du réseau neuronal (5).

**10.** Dispositif détecteur suivant l'une quelconque des revendications de 7 à 9, caractérisé en ce que le réseau neuronal (5) est un réseau à rétro-propagation.

**11.** Dispositif détecteur suivant l'une quelconque des revendications de 7 à 10, caractérisé en ce que le réseau neuronal (5) présente une structure de réseau à un étage, c'est-à-dire une structure de réseau avec une couche cachée.

**12.** Dispositif détecteur suivant la revendication 11, caractérisé en ce que la couche d'entrée du réseau neuronal (5) présente huit, six, autre ou deux noeuds d'entrée.

**13.** Dispositif détecteur suivant l'une ou l'autre des revendications 11 et 12, caractérisé en ce que la couche cachée du réseau neuronal (5) présente cinq, quatre, deux ou un noeuds.

**14.** Dispositif détecteur suivant l'une quelconque des revendications de 7 à 10, caractérisé en ce que le réseau neuronal présente une structure de réseau à deux étages, c'est-à-dire une structure de réseau avec deux couches cachées.

**15.** Dispositif détecteur suivant l'une quelconque des revendications de 7 à 14, caractérisé en ce que la couche de sortie du réseau neuronal (5) présente un noeud de sortie.

**16.** Dispositif détecteur suivant l'une quelconque des revendications de 7 à 15, caractérisé en ce que qu'une fonction sigmoïde adaptée au comportement non linéaire de la bobine de mesure (2) à allure strictement monotone et diffférenciable sert de fonction de transfert du réseau neuronal (5).

**17.** Application du procédé suivant l'une quelconque des revendications de 1 à 6 à la mesure des distances et à la mesure des épaisseurs de couche.

**18.** Application du procédé suivant l'une quelconque des revendications de 1 à 6 à la mesure de la conductivité électrique et de la perméabilité relative effective.

Fig. 1

Fig. 2

EP 0 782 692 B1

Fig. 3

Fig. 4

EP 0 782 692 B1

Fig. 5